# FASCICULE DE BREVET EUROPEEN

(11) **EP 2 912 692 B1**
(45) Date de publication et mention de la délivrance du brevet: **03.06.2020**
(21) Numéro de dépôt: 13783544.3
(22) Date de dépôt: 25.10.2013
(51) Int. Cl.: H01L 29/40, H01L 21/02, H01L 29/66, H01L 29/06, H01L 29/41, B82Y 10/00, B82Y 40/00, H01L 33/00, H01L 33/12, H01L 33/20, C30B 25/18, C30B 29/60, C30B 29/36, C30B 29/16, C30B 25/00, B82Y 20/00, C30B 29/40, H01L 21/66, H01L 33/16

(54) **PROCEDE DE CROISSANCE D'AU MOINS UN NANOFIL A PARTIR D'UNE COUCHE D'UN METAL DE TRANSITION NITRURE OBTENUE EN DEUX ETAPES**
VERFAHREN ZUR ZÜCHTUNG VON MINDESTENS EINEM NANODRAHT AUS EINER SCHICHT EINES ÜBERGANGSNITRIDMETALLS BEI HERSTELLUNG DIESER SCHICHT IN ZWEI STUFEN
METHOD FOR GROWING AT LEAST ONE NANOWIRE FROM A LAYER OF A TRANSITION NITRIDE METAL, SAID LAYER BEING OBTAINED IN TWO STEPS

(30) Priorité: 26.10.2012 FR 1260208
(43) Date de publication de la demande: 02.09.2015
(60) Demande divisionnaire: 20171111.6
(73) Titulaire: Commissariat à l'Énergie Atomique et aux Énergies Alternatives, 75015 Paris (FR); Aledia, 38000 Grenoble (FR)
(72) Inventeur: HYOT, Bérangère, F-38320 Eybens (FR); AMSTATT, Benoit, F-38000 Grenoble (FR); ARMAND, Marie-Françoise, F-38410 Vaulnaveys-le-Haut (FR); DUPONT, Florian, F-38000 Grenoble (FR)
(74) Mandataire: Novaimo
(86) Numéro de dépôt international: PCT/EP2013/072424
(87) Numéro de publication internationale: WO 2014/064263

(56) Documents cités:
- EP-A1- 1 796 180
- EP-A2- 1 246 233

## Description

### Domaine technique de l'invention

L'invention concerne le domaine des matériaux semi-conducteurs et plus précisément celui de la croissance des nanofils semi-conducteurs.

L'invention a pour objet plus particulièrement un procédé de croissance d'au moins un nanofil.

### État de la technique

Dans le domaine de la croissance des nanofils, il est connu de EP1796180A1 de déposer une couche notamment de titane sur la surface d'un substrat de nitrure de gallium préalablement à la croissance des nanofils. Il est également connu d'utiliser des couches de nucléation comme l'AIN (nitrure d'aluminium) ou encore le TiN (nitrure de titane). Ces couches peuvent être déposées directement par LPCVD (dépôt chimique en phase vapeur à basse pression) ou par APCVD (dépôt chimique en phase vapeur à pression atmosphérique) comme le décrit le document WO2011/162715.

Ce document WO2011/162715 précise que les nanofils semi-conducteurs ont une croissance qui peut être favorisée si l'orientation cristallographique d'un substrat cristallin permettant la croissance est orientée selon la direction [111] dans une structure « cubic face centrée de type NaCl », ou selon l'axe 'c' dans une structure « hexagonale ».

Si le substrat n'est pas correctement orienté, il est possible de déposer une couche de nucléation d'AIN ou de TiN dont la structure cristallographique aura une prédominance d'orientation selon la direction [0001] pour l'AIN qui a une structure hexagonale et selon la direction [111] pour le TiN qui a une structure cubique face centrée (cfc).

Il résulte de ce qui a été dit ci-dessus que l'orientation cristallographique du support de croissance pour les nanofils est importante. Il convient donc d'optimiser la prédominance dans une direction correcte d'une structure cristallographique pour favoriser la croissance des nanofils à partir de cette structure cristallographique.

### Objet de l'invention

Le but de la présente invention est de proposer une solution permettant d'améliorer l'orientation cristallographique d'une couche de nucléation d'un ou plusieurs nanofils.

On tend vers ce but par un procédé de croissance d'au moins un nanofil semi-conducteur, ledit procédé de croissance comportant une étape de formation, au niveau d'un substrat, d'une couche de nucléation pour la croissance du nanofil et une étape de croissance du nanofil, en particulier l'étape de formation de la couche de nucléation comporte les étapes suivantes : le dépôt sur le substrat d'une couche d'un métal de transition ledit métal de transition étant le titane; la nitruration d'au moins une partie de la couche de métal de transition de sorte à former une couche de métal de transition nitruré présentant une surface destinée à la croissance du nanofil, la nitruration étant mise en oeuvre avant la croissance du nanofil.

Avantageusement, l'étape de nitruration de ladite couche de métal de transition est réalisée de sorte à modifier au moins en partie la structure cristallographique de la couche de métal de transition vers une structure cristallographique cubique face centrée, notamment orientée [111], ou hexagonale, notamment orientée [0001] ou selon la direction d'axe 'C', associée à la couche de métal de transition nitruré.

Selon une mise en œuvre particulière, l'étape de nitruration comporte : une première sous-étape de nitruration réalisée au moins en partie à une première température en imposant une injection d'un gaz de nitruration selon un premier débit ; une deuxième sous-étape de nitruration réalisée au moins en partie à une deuxième température inférieure ou égale à la première température en imposant une injection du gaz de nitruration selon un deuxième débit distinct, ou non, du premier débit. Par exemple, le gaz de nitruration injecté est de l'ammoniac, et : la première température est comprise entre 1000°C et 1050°C, notamment égale à 1050°C ; le premier débit est compris entre 500^{∗}V/8 sccm et 2500^{∗}V/8 sccm, notamment égal à 1600^{∗}V/8 sccm ; la deuxième température est comprise entre 950°C et 1050°C, notamment égale à 1000°C; le deuxième débit est compris entre 500^{∗}V/8 sccm et 2500^{∗}V/8 sccm, notamment égal à 480^{∗}V/8 sccm ; et où V est la capacité totale en litre d'une enceinte de nitruration correspondante.

Alternativement, l'étape de nitruration comporte une première sous-étape de nitruration réalisée au moins en partie à une première température en imposant une injection d'un gaz de nitruration selon un premier débit, une deuxième sous-étape de nitruration réalisée au moins en partie à une deuxième température supérieure ou égale à la première température en imposant une injection du gaz de nitruration selon un deuxième débit distinct, ou non, du premier débit.

De manière générale, on peut considérer que la première température peut être inférieure ou supérieure ou égale à la deuxième température, et de préférence inférieure ou supérieure à la deuxième température. Selon une mise en œuvre, l'étape de nitruration est réalisée dans une enceinte de nitruration placée à une pression comprise entre 50 mbar et 800 mbar, notamment 100 mbar.

A titre d'exemple, l'étape de croissance du nanofil est réalisée après la deuxième sous-étape de nitruration, ou est initiée au cours de la deuxième sous-étape de nitruration.

De préférence, l'étape de croissance du nanofil comporte une étape d'injection de Ga de sorte à former le nanofil en nitrure de gallium, ledit nanofil s'étendant à partir de la surface de croissance de la couche de nucléation.

Avantageusement, le substrat étant en silicium, l'étape de dépôt de la couche de métal de transition est configurée de sorte que l'interdiffusion du silicium dans la couche de métal de transition déposée soit inférieure à 10 nm et/ou de sorte à conserver une tranche de la couche de métal de transition non siliciurée d'au moins 2 nm.

Ledit métal de transition est déposé à une température inférieure à 100°C.

Avantageusement, le substrat étant à base de silicium, l'étape de dépôt de la couche de métal de transition comprend une étape préalable de détermination de l'épaisseur de la couche de métal de transition à déposer comprenant : une étape de détermination d'une première longueur de diffusion du silicium dans la couche de métal de transition au cours du futur dépôt de la couche de métal de transition en fonction de la température de dépôt ; une étape de détermination d'une deuxième longueur de diffusion du silicium dans la couche de métal de transition au cours de la future étape de nitruration de la couche de métal de transition ; ladite épaisseur de la couche de métal de transition à déposer étant fonction de l'épaisseur désirée de la couche de métal de transition nitruré et d'une épaisseur d'une tranche de métal de transition siliciuré obtenue dans la future couche de métal de transition à partir des première et deuxième longueurs de diffusion déterminées.

Selon une mise en œuvre du procédé de croissance, il comporte une étape dans laquelle on prévoit le substrat de sorte que ce dernier présente une résistivité comprise entre 1 mΩ.cm et 100 mΩ.cm. Avantageusement, le procédé de croissance comporte, avant dépôt de la couche de métal de transition, une étape de désoxydation d'une surface du substrat destinée à recevoir la couche de métal de transition.

En outre, l'étape de dépôt de ladite couche de métal de transition et l'étape de nitruration sont mises en œuvre avant l'étape de croissance.

L'invention est aussi relative à un procédé de fabrication d'un dispositif opto-électronique, ledit procédé comportant : une étape de mise en œuvre du procédé de croissance ; le dopage électrique d'un premier type d'au moins une extrémité du nanofil opposée au substrat ; la formation d'un élément dopé électriquement d'un deuxième type opposé au premier type au niveau de l'extrémité du nanofil opposée au substrat. En outre, un tel procédé peut aussi comporter une étape de formation de puits quantiques disposés au niveau de l'interface entre le nanofil et l'élément dopé électriquement du deuxième type.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- la figure 1 est une vue en coupe d'une étape de formation d'une couche de nucléation,
- la figure 2 est une vue en coupe d'une étape de nucléation d'au moins un nanofil à partir de la couche de nucléation,
- la figure 3 illustre une représentation du spectre de diffraction des rayons X permettant d'identifier les types de structures cristallographiques présentes dans une couche de métal de transition à base de Nb avant nitruration et après nitruration,
- la figure 4 illustre une représentation du spectre de diffraction des rayons X permettant d'identifier les types de structures cristallographiques présentes dans une couche de métal de transition à base de Hf avant nitruration et après nitruration,
- la figure 5 représente en détails une réalisation d'une étape de nitruration,
- les figures 6 et 7 illustrent différentes étapes permettant de mener à la réalisation d'une couche de nucléation,
- la figure 8 illustre un mode de réalisation particulier d'un procédé de fabrication d'un dispositif opto-électronique,
- la figure 9 illustre en détails une autre réalisation d'une étape de nitruration selon une mise en œuvre de l'invention.

### Description de modes préférentiels de l'invention

Le procédé décrit ci-après diffère de l'art antérieur notamment en ce que la couche de nucléation est réalisée à partir de deux étapes, d'abord un dépôt d'un métal de transition, puis une nitruration au moins partielle de ce métal de transition. Cette succession particulière d'étapes permet de conférer à la couche de nucléation une meilleure surface destinée à la croissance des nanofils.

Le terme 'microfil' ou 'nanofil' dans la suite de la description, signifie préférentiellement une structure tridimensionnelle de forme allongée dont la dimension longitudinale est au moins égale à une fois la ou les dimensions transversales, de préférence au moins cinq fois et encore plus préférentiellement au moins dix fois. La ou les dimensions transversales sont comprises entre 5 nm et 2,5 µm. Dans certains modes de réalisation, les dimensions transversales peuvent être inférieures ou égales à environ 1 µm, de préférence comprises entre 100 nm et 300 nm. Dans certains modes de réalisation, la hauteur de chaque nanofil peut être supérieure ou égale à 500 nm, de préférence comprise entre 1 µm et 50 µm.

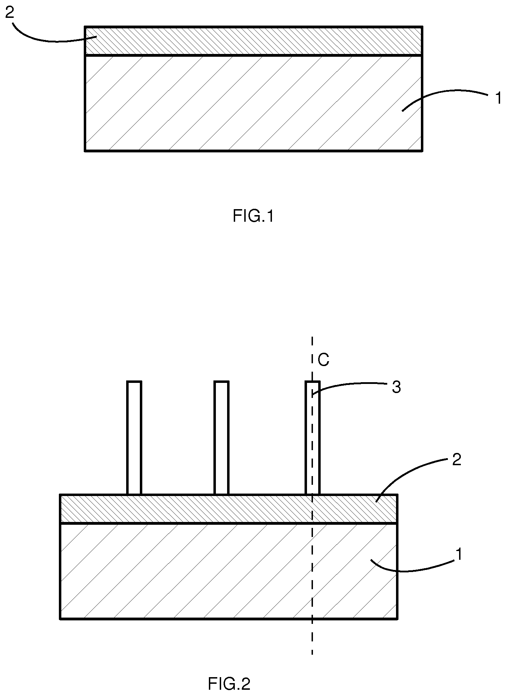

Comme illustré à la figure 1, le procédé de croissance d'au moins un nanofil semi-conducteur comporte une étape de formation, au niveau d'un substrat 1, d'une couche de nucléation 2 pour la croissance du nanofil et une étape de croissance du nanofil 3 (figure 2). Bien entendu, l'étape de croissance du nanofil 3 permet à ce dernier de croître à partir de la couche de nucléation 2.

Il a été donné un exemple se basant sur la croissance d'un nanofil, cependant le procédé de croissance n'est pas limité à ce seul exemple et permet, lors de l'étape de croissance, de faire croître une pluralité de nanofils côte-à-côte à partir de la couche de nucléation 2.

On comprend de ce qui vient d'être dit, que la couche de nucléation 2 a comme fonction première de favoriser la nucléation du ou des nanofils 3. En outre, cette couche de nucléation 2 est préférentiellement choisie de sorte à protéger le substrat 1 d'une éventuelle dégradation lors de la croissance (ce qui peut être le cas si le substrat est en silicium et le nanofil en nitrure de gallium), et/ou à conserver une bonne stabilité aux hautes températures (cas des températures supérieures à 500°C), et/ou à conférer une bonne conduction électrique notamment lorsque l'on souhaite polariser chaque nanofil 3 et injecter du courant par le substrat 1.

Concernant le substrat 1, le procédé peut, de manière non limitative, comporter une étape dans laquelle on prévoit le substrat 1 de sorte que ce dernier présente une résistivité comprise entre 1 mΩ.cm et 100 mΩ.cm. Cette résistivité présente un intérêt lorsque l'on souhaite polariser les nanofils comme indiqué ci-dessus au travers de la couche de nucléation 2.

Dans un premier temps, il convient de noter qu'une couche de nucléation 2 permet de favoriser la croissance d'un ou plusieurs nanofils 3 lorsque ces derniers croissent à partir de cette couche de nucléation 2 en grande majorité de manière sensiblement perpendiculaire au substrat 1 (axe C représenté à la figure 2). Par « sensiblement perpendiculaire », on entend exactement perpendiculaire ou perpendiculaire à plus ou moins 10 degrés. Cette légère désorientation de plus ou moins 10 degrés autorise tout de même la réalisation d'étapes technologiques ultérieures permettant de réaliser des dispositifs plus complets.

On va donc rechercher à avoir, au niveau de la couche de nucléation, une orientation cristallographique adaptée pour la croissance des nanofils 3. De plus, si cette orientation cristallographique est dense, c'est-à-dire prédominante, la densité de ces nanofils 3 peut alors être magnifiée.

Pour cela, l'étape de formation de la couche de nucléation comporte une étape de dépôt sur le substrat 1 d'une couche d'un métal de transition 4, ledit métal de transition étant le titane, puis une étape de nitruration d'au moins une partie de la couche de métal de transition de sorte à former une couche de métal de transition nitruré (nitrure de titane) présentant une surface destinée à la croissance du ou des nanofils 3. Afin d'optimiser la croissance, cette couche de métal de transition nitruré peut avoir une épaisseur minimale de 2 nm, et de préférence comprise entre 2 nm et 50 nm.

Selon une réalisation, le dépôt de la couche de métal de transition est réalisé à une température comprise entre la température ambiante et 400°C. Au-delà, il existe un risque de baisse du rendement de croissance de nanofils.

On préférera une épaisseur de 20 nm pour la couche de métal de transition. Le dépôt peut être réalisé par PVD (dépôt physique par phase vapeur) à partir d'une cible métallique, par exemple une pulvérisation à courant continu parcourant la cible. Au cours de cette étape de dépôt du métal de transition, le substrat 1 peut être maintenu à température ambiante. De manière générale applicable à toute la description par « température ambiante », on entend une température de préférence comprise entre 20°C et 50°C. La pression dans l'enceinte PVD durant le dépôt du métal de transition peut être comprise entre 3.10⁻³ mbar et 6.10⁻³ mbar

Après différents tests, il a été possible d'observer que la croissance de nanofil(s) était favorisée par cette couche de nucléation 2 formée en deux étapes.

En fait, il s'avère que la couche de métal de transition nitruré ainsi formée présente des sites de croissance dont l'orientation cristallographique est propice à la croissance des nanofils. Ces sites de croissance sont en plus grand nombre et présentent une meilleure répartition que dans l'art antérieur, notamment en comparant une couche de nucléation en nitrure de titane réalisée selon le procédé de l'invention par rapport à la couche de nitrure de titane déposée en une seule étape de l'art antérieur. En outre, cela permet d'éviter l'éventuelle formation d'un alliage de métal-gallium lors de la croissance des nanofils à base de gallium. Ainsi, on comprend qu'avantageusement, l'étape de dépôt de ladite couche de métal de transition et l'étape de nitruration sont mises en œuvre avant l'étape de croissance du nanofil.

De plus, le fait de choisir selon l'invention le titane parmi les métaux de transition suivants : Ti, V, Cr, Zr, Nb, Mo, Hf, Ta, pour former, après nitruration dudit métal de transition, la couche de nucléation 2 permet de combiner des caractéristiques de conduction électrique de type métallique et de caractère réfractaire d'une céramique. Ces propriétés a priori antagonistes peuvent être atteintes par les métaux de transition cités ci-dessus. En fait, le caractère réfractaire peut être atteint par un matériau dont le point de fusion est associé à une température supérieure à environ 1800°C, ce qui est le cas pour le nitrure des métaux de transition visés ci-dessus. Le tungstène pourtant présent dans la même colonne que le chrome et le molybdène est écarté de la liste car le nitrure de tungstène présente des caractéristiques insuffisantes de stabilité aux hautes températures, ce qui ne permet pas une croissance efficace des nanofils.

La couche de métal de transition nitruré ainsi obtenue permet, en outre, grâce au métal de transition utilisé, de présenter un gap plus faible que les couches de nucléation à base d'AIN très utilisées à ce jour comme couche de nucléation. Ainsi, lorsque le substrat 1 est à base de silicium, la couche de nucléation 2 selon l'invention présente à son interface avec le substrat une barrière de potentiel plus facilement franchissable que dans le cas où on utilise de l'AIN, ceci conférant un avantage lorsque l'on souhaite polariser un ou plusieurs nanofils à partir du substrat 1.

Il résulte de ce qui a été dit précédemment que l'orientation cristallographique de la couche de nucléation 2, notamment au niveau d'une surface destinée à la croissance du ou des nanofils, revêt une importance dans le cadre de la favorisation de la croissance de nanofil(s). Ainsi, l'étape de dépôt de la couche de métal de transition est préférentiellement réalisée de sorte à ce que ladite couche de métal de transition présente, avant l'étape de nitruration, au moins en partie une structure cristallographique de type cubique centrée (CC) ou hexagonale (ces deux structures cristallographiques sont celles des métaux cités ci-dessus).

Dans la présente description, lorsque l'on parle de prédominance d'une structure cristallographique, on entend que cette dernière apparait en proportion plus grande que chacune des autres structures cristallographiques prise indépendamment.

Typiquement, pour les métaux de transition visés ci-dessus, la structure cubique centrée (CC) peut être obtenue naturellement par dépôt d'une couche d'un métal de transition choisi parmi Cr, Mo, V, Nb, Ta, et la structure hexagonale peut être obtenue naturellement par le dépôt d'une couche d'un métal de transition choisi parmi Ti, Zr, Hf.

Les structures cristallographiques spécifiques visées précédemment permettent de réaliser l'étape de nitruration de ladite couche de métal de transition ou au moins une partie de la couche de métal de transition de sorte à modifier au moins en partie la structure cristallographique de la couche de métal de transition vers une structure cristallographique cubique face centrée, notamment orientée [111], ou hexagonale, notamment orientée [0001] ou selon la direction d'axe 'C', associée à la couche de métal de transition nitruré.

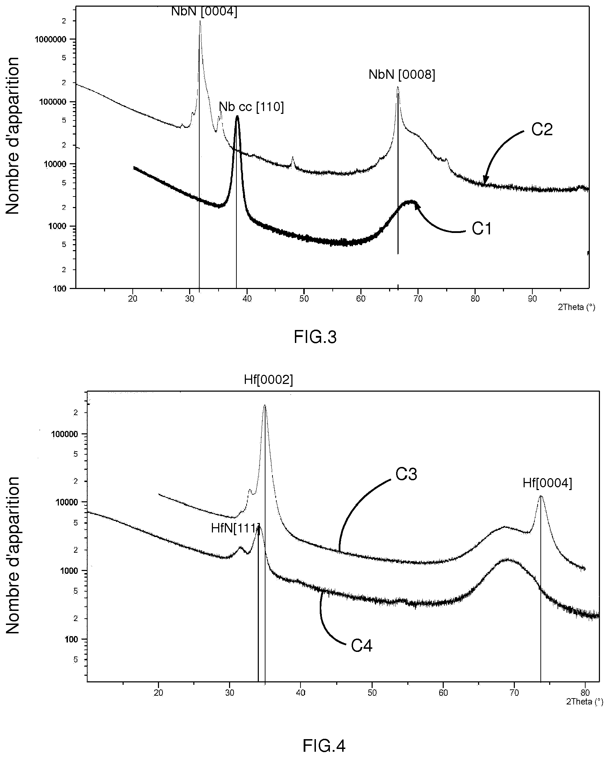

Les figures 3 et 4 illustrent chacune un spectre de diffraction des rayons X permettant d'identifier les phases ou structures cristallographiques en présence. La figure 3 montre que pour la courbe C1 représentative de la structure cristallographique de la couche de métal de transition de type Nb avant nitruration on a bien une prédominance de l'orientation [110] de la structure cubique centrée (CC) du Nb, et que pour la courbe C2 représentative de la structure cristallographique hexagonale de la couche de métal de transition nitrurée NbN on a bien une prédominance de l'orientation [0004] de la structure hexagonale et de son harmonique d'orientation [0008], c'est-à-dire d'orientation similaire à [0001]. La figure 4 montre que pour la courbe C3 représentative de la structure cristallographique hexagonale de la couche de métal de transition de type Hf avant nitruration on a bien une prédominance de l'orientation [0002] de la structure hexagonale, et que pour la courbe C4 représentative de la structure cristallographique cubique face centrée de la couche de métal de transition nitruré HfN on a bien une prédominance de l'orientation [111] de la structure cubique face centrée. Sur les figures 3 et 4, seuls les pics ont une importance pour visualiser la prédominance, le reste de la courbe représentant un fond continu dû au dispositif expérimental et à l'échantillon. Des courbes similaires peuvent être réalisées par l'homme du métier pour les autres métaux de transition et les conclusions seraient sensiblement identiques, par exemple pour du nitrure de tantale, on aurait prédominance de l'orientation [111] de la structure cubique face centrée du nitrure de tantale.

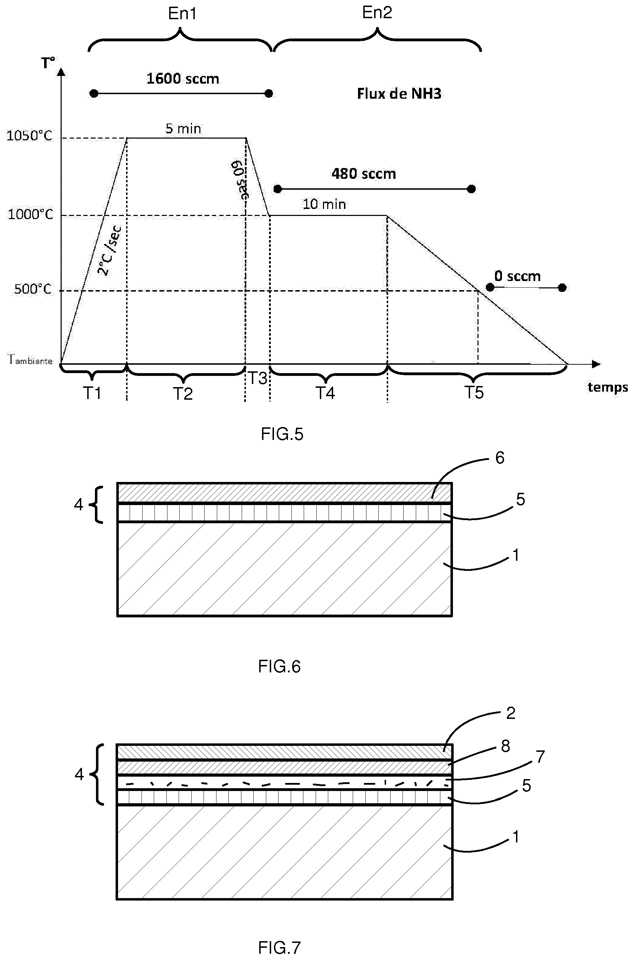

Selon une mise en œuvre particulière, notamment illustrée à la figure 5, l'étape de nitruration peut comporter une première sous-étape de nitruration En1 réalisée au moins en partie à une première température en imposant une injection d'un gaz de nitruration selon un premier débit, et une deuxième sous-étape de nitruration En2 réalisée au moins en partie à une deuxième température inférieure ou égale à la première température en imposant une injection du gaz de nitruration selon un deuxième débit distinct, ou non (c'est-à-dire que le premier débit peut être égal au deuxième débit), du premier débit. Ceci permet d'optimiser l'orientation cristallographique de la couche de nucléation. Il va de soi que ces deux sous-étapes de nitruration sont réalisées l'une après l'autre. En particulier, la première sous-étape En1 permet de réaliser une nitruration rapide et la deuxième sous-étape En2 permet de réaliser un recuit stabilisant la phase de nitrure du métal de transition. Consécutivement à ces deux sous-étapes En1 et En2, la couche de métal de transition nitruré est chimiquement et thermiquement stable et peut assurer une fonction de protection du substrat (en particulier si celui-ci est en silicium) pendant la croissance du ou des nanofils.

Le gaz injecté peut être de l'ammoniac NH₃ ou du diazote N₂. Le NH₃ est préféré car il permet de nitrurer plus rapidement la couche de métal de transition. En fait, sous la forme NH₃, le pouvoir nitrurant est plus important que pour le N₂. Cette nitruration rapide peut être importante surtout si le métal de transition est susceptible de se transformer en siliciure, ce point est abordé ci-après.

Selon un exemple particulier, le gaz de nitruration injecté étant de l'ammoniac, la première température est comprise entre 1000°C et 1050°C, notamment égale à 1050°C, le premier débit est compris entre 500 sccm et 2500 sccm (sccm est une unité de débit issue de l'anglais « standard cubic centimeters per minute », soit des centimètres cube par minute), notamment égal à 1600sccm, la deuxième température est comprise entre 950°C et 1050°C, notamment égale à 1000°C, le deuxième débit est compris entre 500 sccm et 2500 sccm, notamment égal à 500 sccm.

Les débits mentionnés ci-dessus correspondent à la capacité volumique de l'enceinte nitruration utilisée, soit un volume total de gaz (par exemple N₂+NH₃) de 8 litres dans l'exemple mentionné. Pour une enceinte de volume différent, les débits devront être adaptés (par exemple : pour une enceinte de 18 litres, le premier débit devra être notamment égal à 4000 sccm et le deuxième débit notamment égal à 1200 sccm). Autrement dit, le premier débit est compris entre 500^{∗}V/8 sccm et 2500^{∗}V/8 sccm, notamment égal à 1600^{∗}V/8 sccm, et le deuxième débit est compris entre 500^{∗}V/8 sccm et 2500^{∗}V/8 sccm, notamment égal à 500^{∗}V/8 sccm. V est la capacité totale en litre d'une enceinte de nitruration correspondante. Par « enceinte de nitruration correspondante », on entend ici l'enceinte dans laquelle la nitruration de la couche de métal de transition est réalisée.

De manière générale, l'étape de nitruration peut être réalisée dans une enceinte de nitruration placée à une pression comprise entre 50 mbar et 800 mbar, notamment 100 mbar.

La figure 5 illustre de manière détaillée l'étape de nitruration en représentant l'évolution de la température en fonction du temps dans une enceinte de nitruration. Dans un premier temps T1, la température dans l'enceinte de nitruration monte progressivement, par exemple de 2°C/s jusqu'à atteindre un pallier 1050°C. La première sous-étape de nitruration sous NH₃ En1 visée ci-dessus commence lorsque la température atteint 200°C. Au cours de cette première sous étape, le débit de NH₃ reste constant à 1600sccm. Dans un deuxième temps T2, concomitant à au moins une partie de la première sous-étape, la température est maintenue à 1050°C pendant un temps compris entre 5 minutes et 15 minutes. Dans un troisième temps T3, la première sous-étape En1 est continuée alors que la température passe de 1050°C à 1000°C en 60s. Dans un quatrième temps T4, la température dans l'enceinte de nitruration est maintenue à 1000°C pendant un temps compris entre 5 minutes et 15 minutes et la deuxième sous-étape En2 est débutée. Dans un cinquième temps T5, l'apport de calories dans l'enceinte de nitruration est stoppé de sorte que l'enceinte de nitruration redescende en température jusqu'à revenir à la température ambiante. La durée de T5 peut correspondre à l'inertie de l'enceinte de nitruration. La deuxième sous-étape de nitruration En2 peut être continuée pendant un temps déterminé au cours du cinquième temps T5. Le cinquième temps T5 peut correspondre à un arrêt du chauffage de l'enceinte puis à sa redescente en température ou peut également correspondre à une étape de croissance des nanofils si l'enceinte utilisée pour la nitruration est aussi l'enceinte de MOCVD dédiée à la synthèse des nanofils. Selon une mise en œuvre particulière, l'étape de croissance du nanofil 3 est réalisée après la deuxième sous-étape En2 de nitruration, ou est initiée au cours de la deuxième sous-étape En2 de nitruration.

De manière générale, l'étape de croissance dudit au moins un nanofil 3 peut comporter une étape d'injection d'un matériau destiné à former au moins en partie le nanofil 3. En particulier, il s'agira d'une injection de Ga de sorte à former le nanofil 3 en nitrure de gallium, ledit nanofil 3 s'étendant à partir de la surface de croissance de la couche de nucléation 2. Pour former le nanofil en nitrure de gallium, l'injection de Ga pourra être réalisée concomitamment avec une injection de NH₃ ou de N₂. En général pour la synthèse de GaN, c'est la réaction du Ga avec le NH₃ et non avec le N₂ qui est utilisée. L'injection de Ga peut être réalisée dans une enceinte adaptée à la croissance de nanofils.

L'utilisation du nitrure de gallium pour former ledit au moins un nanofil 3 procure au moins deux avantages.

Un premier avantage est que les structures cubiques faces centrées, ou hexagonales de la couche de métal de transition nitruré (donc de la couche de nucléation 2) sont favorables à une épitaxie du nitrure de gallium. Des nanofils en nitrure de gallium, dont la structure cristallographique est une structure hexagonale de type wurtzit orientée selon l'axe C (ou selon l'axe [0001]) de la figure 2, peuvent facilement être nucléés à partir de la couche de nucléation 2 telle que décrite. Alternativement, les nanofils peuvent aussi être réalisés en ZnO, InN ou SiC.

Un deuxième avantage est que le nitrure de gallium est un bon candidat dans l'expectative de former un dispositif opto-électronique. En effet, un tel nanofil en nitrure de gallium permet de former un nano-émetteur de lumière. Des puits quantiques à base de GaN peuvent être ajoutés soit sous forme de coquille autour du nanofil, soit dans la continuité de l'axe du nanofil (structure axiale). Suivant la composition de ces puits quantiques à base de GaN, le domaine spectral de l'émission de lumière pourra couvrir une large gamme de longueur d'onde allant de l'ultra-violet à l'infra-rouge.

Afin de réaliser une croissance optimisée de nanofils, il est préférable que la couche de métal de transition soit peu siliciurée. Le phénomène de siliciuration de la couche de métal de transition peut intervenir, si le substrat 1 est à base de silicium, selon deux cas : au cours de l'étape de dépôt du métal de transition, et/ou lorsque l'on cherche à nitrurer la couche de métal de transition déposée pour délimiter la couche de nucléation 2.

Le premier cas peut s'expliquer de la manière qui va suivre. En fait, à haute température (environ 1000°C), la formation des composés siliciurés MSi₂ est favorisée (M étant le métal de transition utilisé). Parmi ces siliciures, seuls les siliciures des métaux de transition de la colonne V (VSi₂, NbSi₂, TaSi₂), plus le siliciure de Cr (CrSi₂) forment des phases cristallographiques à structure hexagonale, potentiellement intéressantes (si texturées selon l'axe c) pour la croissance des nanofils de GaN. Cependant le désaccord de paramètre de maille « a » entre ces phases hexagonales et le GaN (3.19 Å) est si important, respectivement de - 30%, -36%, -33% et -25% pour le VSi₂, NbSi₂, TaSi₂, le CrSi₂ que l'épitaxie du GaN est très improbable. Typiquement, le paramètre de maille « a » pour les composés hexagonaux VSi₂, NbSi₂, TaSi₂, CrSi₂, est de respectivement : 4.57 Å, 4.97 Å, 4.78 Å et 4.28 Å. Ainsi, une sous-famille peut être formée des matériaux suivants : Ti, V, Cr, Nb, Ta, Mo, c'est-à-dire des métaux dont le coefficient d'interdiffusion avec le Si est élevé, ce qui implique une cinétique de croissance de la nouvelle phase MSi₂ rapide. A titre d'exemple, le Cr présente un coefficient d'interdiffusion avec le Si à 850°C de 1,5.10⁻⁷ cm²/s soit une longueur de diffusion d'environ 11,6 µm en 15 minutes, alors qu'aux alentours des 100°C cette longueur de diffusion descend à environ 80 nm en 15 minutes. Pour les raisons évoquées ci-dessus, si le métal de transition déposé est choisi parmi Cr, V ou Ti, il est préférentiellement déposé à une température inférieure à 100°C afin de de limiter la diffusion du silicium issu du substrat. Pour le Nb, la longueur d'interdiffusion Nb-Si pendant 15 minutes est de 12 nm et 2 nm pour respectivement 800°C et 700°C. Le Nb peut donc être déposé à haute température jusqu'à 700-750°C sans -ou avec un très faible- phénomène de siliciuration. Les autres matériaux : Zr, Hf et Ta présentant des coefficients d'interdiffusion avec le Si plus faible que le Nb peuvent donc être aisément déposés depuis la température ambiante jusqu'à 750°C-800°C au plus. Une siliciuration trop importante aurait pour conséquence de ne pas permettre l'obtention plus tard d'une couche de métal de transition nitrurée d'épaisseur suffisante. Autrement dit, pour généraliser, le substrat 1 étant en silicium, l'étape de dépôt de la couche de métal de transition est configurée de sorte que l'interdiffusion du silicium dans la couche de métal de transition déposée soit inférieure à 10 nm et/ou de sorte à conserver une tranche de la couche de métal de transition non siliciurée d'au moins 2 nm. En fait, cette tranche non siliciurée est opposée au substrat et est destinée à former la couche nitrurée du métal de transition. A la figure 6, la référence 4 indique la couche de métal de transition initialement déposée sur le substrat 1, au cours du dépôt de la couche 4, une tranche 5 de cette couche peut s'être siliciurée de sorte que seule une partie 6 de la couche 4 est composée du métal de transition pur pouvant servir à former, par nitruration, la couche de nucléation.

Dans le deuxième cas, l'étape de nitruration peut nécessiter de travailler à 1050°C pendant quelques minutes. Pour cela, on préférera utiliser comme gaz nitrurant du NH₃ car grâce à son haut pouvoir nitrurant la vitesse de réaction de nitruration est supérieure à celle de la siliciuration. En fait, dans l'idéal, on cherche à former (figure 7) au cours de l'étape de nitruration au moins une couche de métal de transition nitruré 2 (c'est-à-dire la couche de nucléation) dans la couche de métal de transition 4 déposée, l'épaisseur de ladite couche de métal de transition nitruré étant comprise avantageusement entre 2 nm et 50 nm. Afin d'éviter l'obtention d'un nouveau composé siliciuré important au niveau de cette couche de métal de transition nitruré, on optimisera l'étape de nitruration. En fait, après l'étape de nitruration, on comprend comme illustré à la figure 7 que la couche 4 que l'on cherchait à réaliser en déposant un métal de transition peut comporter en fait une première couche de métal de transition siliciuré 5 obtenue au cours du dépôt dudit métal de transition, une deuxième couche de métal de transition siliciuré 7 disposée dans la continuité de la première couche de métal de transition siliciuré 5 obtenue lors de l'étape de nitruration et la couche de nucléation 2 issue de la nitruration de la couche 6 de la figure 6. Optionnellement, il est aussi possible qu'il reste une couche 8 résiduelle de métal de transition pur intercalée entre la couche 2 et la couche 7, ceci étant en partie dépendant de l'épaisseur initialement déposée de métal de transition.

Il résulte de l'explication des premier et deuxième cas que, si le substrat 1 est en silicium, l'homme du métier sera apte à déterminer l'épaisseur de la couche de métal de transition qu'il cherche à déposer en fonction du type de métal de transition à déposer, de la température de dépôt du métal de transition, de la durée du dépôt du métal de transition, ainsi que de la durée de l'étape de nitruration afin qu'il soit possible d'obtenir une couche d'une épaisseur prédéterminée de métal de transition nitruré. Autrement dit, pour un substrat à base de silicium, l'étape de dépôt de la couche de métal de transition 4 peut comprendre une étape préalable de détermination de l'épaisseur de la couche de métal de transition 4 à déposer, ladite étape de détermination de l'épaisseur comprenant : une étape de détermination d'une première longueur de diffusion du silicium dans la couche de métal de transition 4 au cours du futur dépôt de la couche de métal de transition 4 en fonction du métal de transition utilisé et de la température de dépôt ; une étape de détermination d'une deuxième longueur de diffusion du silicium dans la couche de métal de transition 4 au cours de la future étape de nitruration de la couche de métal de transition 4. Ladite épaisseur de la couche de métal de transition à déposer étant fonction de l'épaisseur désirée de la couche de métal de transition nitruré et d'une épaisseur d'une tranche de métal de transition siliciuré obtenue dans la future couche de métal de transition 4 à partir des première et deuxième longueurs de diffusion déterminées.

De manière générale, le substrat 1 sera avantageusement préparé avant le dépôt de la couche de métal de transition 4. Pour cela, le procédé peut comporter, avant l'étape de dépôt de la couche de métal de transition, une étape de désoxydation d'une surface du substrat 1 destinée à recevoir le dépôt de la couche de métal de transition 4. Plus particulièrement, cette étape de désoxydation de la surface du silicium peut être réalisée soit par voie chimique (bain HF) soit par voie physique (« etch » de la surface en appliquant une tension bias sur le substrat 1).

Ceci permet notamment de retirer la couche d'oxyde natif de silice (SiO2) qui est une barrière 'isolante' à l'injection des électrons dans la couche de nucléation et dans le nanofil de nitrure de gallium.

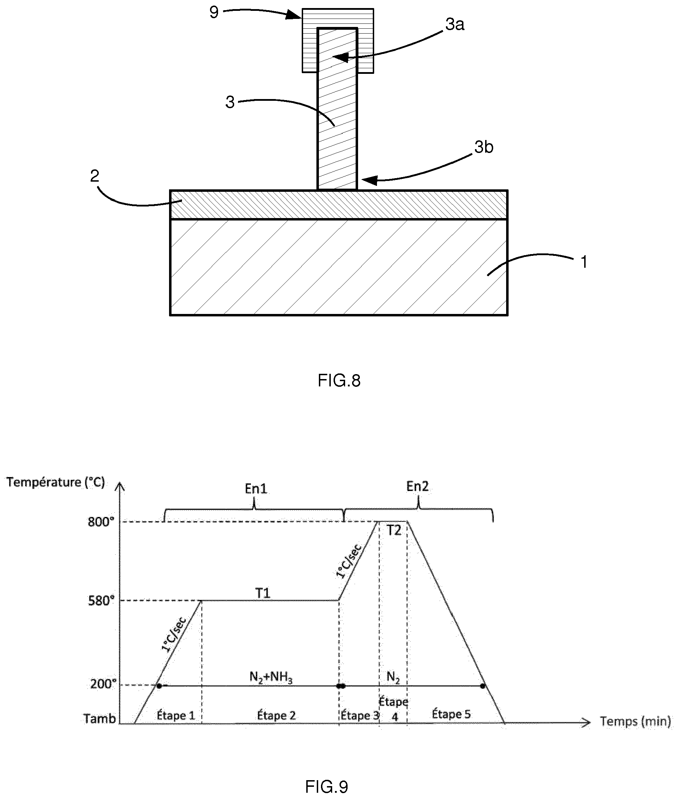

De manière préférentielle, le procédé de croissance décrit ci-avant peut être utilisé dans le cadre de la formation d'un dispositif opto-électronique. Ainsi, l'invention peut aussi être relative à un procédé de fabrication d'un dispositif opto-électronique (figure 8). Un tel procédé de fabrication comporte une étape de mise en œuvre du procédé de croissance tel qu'il est revendiqué. notamment dans ses différentes mises en œuvre ou réalisations. Par ailleurs, le procédé comporte en outre une étape de dopage électrique d'un premier type d'au moins une extrémité 3a du nanofil 3 opposée au substrat 1. Ce premier type est, de préférence, un dopage de type n. En outre, le procédé comporte aussi une étape de formation d'un élément 9 dopé électriquement d'un deuxième type opposé au premier type au niveau de l'extrémité 3a du nanofil 3 opposée au substrat 1. Ce deuxième type de dopage est préférentiellement de type p. Ainsi, l'extrémité 3a du nanofil 3 et l'élément 9 dopé associé à cette extrémité 3a forment une jonction d'une diode destinée à émettre de la lumière. Cette jonction est, de préférence, une homojonction, c'est-à-dire que le nanofil 3 et l'élément 9 dopé associé sont à base de mêmes matériaux comme par exemple le nitrure de gallium. La réalisation d'une hétérojonction est aussi possible, par exemple on peut utiliser le ZnO sous forme de nanofil dopé n, puis ajouter des puits quantiques à base de ZnO et utiliser l'élément 9 en GaN dopé électriquement p. En fait, il est actuellement difficile de doper p le ZnO.

La figure 8 illustre un exemple particulier du dispositif opto-électronique obtenu à partir du procédé de fabrication. On retrouve donc le substrat 1, de préférence en silicium et configuré de sorte à être électriquement conducteur (par exemple dopé n), une face du substrat 1 est orientée vers la couche de nucléation 2. De cette couche de nucléation 2 s'étend le nanofil 3. Par « s'étend », on entend que le nanofil 3 présente une longueur définie entre deux extrémités longitudinales 3a, 3b, une première extrémité longitudinale 3b étant en contact avec la couche de nucléation 2 et une deuxième extrémité longitudinale 3a étant distante de la couche de nucléation 2. L'élément 9 dopé de sorte à former une jonction avec la deuxième extrémité 3a du nanofil 3 peut recouvrir au moins en partie le nanofil 3 au niveau de ladite deuxième extrémité 3a. De préférence, l'élément 9 dopé forme un fourreau autour de l'extrémité 3a du nanofil 3.

Par ailleurs, dans le cadre d'un dispositif opto-électronique, il peut être avantageux d'ajouter des puits quantiques destinés à former des zones de confinement afin d'augmenter le rendement d'émission du nanofil 3. Ainsi, le procédé de fabrication du dispositif opto-électronique peut comporter une étape de formation de puits quantiques disposés au niveau de l'interface entre le nanofil 3 et l'élément 9 dopé électriquement du deuxième type. Les puits quantiques peuvent être déposés sous forme de coquille autour du nanofil. La composition du matériau constituant les puits quantiques est ajustée de façon à ce que l'émission de lumière se fasse à la longueur d'onde choisie. Les puits quantiques sont formés dans une couche supplémentaire prise en sandwich entre le nanofil et l'élément 9.

De préférence, des nanofils associés à une même surface de nucléation sont polarisés simultanément par la couche nitrurée formant la couche de nucléation 2. En utilisant un substrat 1 de silicium faiblement résistif, les résistances électriques des différents métaux de transition et de leurs nitrures sont correctes et en cohérence avec la littérature. Un intérêt d'utiliser les nitrures de métaux de transition décrits jusqu'à présent est effectivement qu'ils permettent la nucléation puis la croissance des nanofils de GaN mais un autre intérêt important de ces matériaux est qu'ils n'introduisent pas de barrière de potentiel sur le passage du courant (contrairement à l'AIN par exemple).

De préférence, la structure cristallographie prédominante du substrat est d'orientation [100] au moins au niveau de l'interface entre le substrat et la couche de métal de transition. Ceci permet notamment de diminuer les coûts de fabrication.

Selon une alternative à la réalisation de la figure 5, l'étape de nitruration comporte une première sous-étape de nitruration En1 réalisée au moins en partie à une première température en imposant une injection d'un gaz de nitruration selon un premier débit, une deuxième sous-étape de nitruration En2 réalisée au moins en partie à une deuxième température supérieure ou égale à la première température en imposant une injection du gaz de nitruration selon un deuxième débit distinct, ou non (c'est-à-dire que le premier débit peut être égal au deuxième débit), du premier débit.

Cette alternative de la figure 5 est illustrée à la figure 9. Ainsi, sur la figure 9, la température T1 est comprise entre 400°C et 1050°C (ou 1400°C), notamment entre 500°C et 800°C, et de façon préférentielle égale à 600°C.

La première sous-étape En1 est découpée par souci de clarté en deux étapes : étape 1 et étape 2.

Dans l'étape 1 de la figure 9, on observe une montée en température jusqu'à T1 (c'est-à-dire la première température). Les gaz porteurs sont N₂, N₂+H₂, ou H₂, de façon préférentielle N₂. Le gaz de nitruration injecté peut être de l'ammoniac (NH₃) et l'injection peut commencer pour une température comprise entre Tamb (représentative de la température ambiante) et T1 ; notamment dès 200°C. La rampe de montée en température de Tamb jusqu'à T1 est supérieure à 1 °C/min, et notamment égale à 1°C/sec. Au cours de cette étape 1, le débit d'ammoniac peut être compris entre 10xV/18 sccm et 4000xV/18 sccm, notamment égal à 1200xV/18 sccm (où V est le volume de l'enceinte en litres). De manière générale, le ratio des flux d'ammoniac sur azote (NH₃/N₂) peut être compris entre 0.0005% et 100%, de préférence entre 0,0055% et 22%, et notamment égal à 6.6%.

Dans l'étape 2 de la figure 9, il est réalisé un recuit à T1. Les gaz porteurs sont N₂, N₂+H₂, ou H₂, de façon préférentielle N₂. Le gaz de nitruration injecté peut être de l'ammoniac (NH₃). Le débit d'ammoniac peut être compris entre 10xV/18 sccm et 4000xV/18 sccm, notamment égal à 1200xV/18 sccm (où V est le volume de l'enceinte en litres). De manière générale, le ratio des flux d'ammoniac sur azote (NH₃/N₂) peut être compris entre 0.0005% et 100%, de préférence entre 0,0055% et 22%, notamment égal à 6.6%. De préférence, le temps de recuit sous NH₃ supérieur à 1 seconde, notamment compris entre 5 minutes et 30 minutes.

La deuxième sous-étape En2 est découpée par souci de clarté en trois étapes : étape 3, étape 4 et étape 5. De préférence, la deuxième température T2 est comprise entre 400°C et 1050°C (ou 1400°C), notamment entre 500°C et 1000°C, et de façon préférentielle égale à 800°C. A l'étape 3 (si T1≠T2 sinon on passe directement à l'étape 4) on a une montée en température jusqu'à T2. Les gaz porteurs sont N₂, N₂+H₂, ou H₂, de façon préférentielle N₂. Le gaz de nitruration injecté peut être de l'ammoniac (NH₃). La rampe de montée en température de jusqu'à T2 est supérieure à 1°C/min et notamment égale à 1°C/sec. Le débit d'ammoniac peut être compris entre 10xV/18 sccm et 4000xV/18 sccm, notamment égal à 1200xV/18 sccm (où V est le volume de l'enceinte en litres). De manière générale, le ratio des flux d'ammoniac sur azote (NH₃/N₂) peut être compris entre 0.0005% et 100%, de préférence entre 0,0055% et 22%, notamment égal à 6.6%.

A l'étape 4, il est effectué un recuit à T2. Les gaz porteurs sont N₂, N₂+H₂, ou H₂, de façon préférentielle N₂. Le gaz de nitruration injecté peut être de l'ammoniac (NH₃). Le débit d'ammoniac peut être compris entre 10xV/18 sccm et 4000xV/18 sccm, notamment égal à 1200xV/18 sccm (où V est le volume de l'enceinte en litres). De manière générale, le ratio des flux d'ammoniac sur azote (NH₃/N₂) peut être compris entre 0.0005% et 100%, de préférence entre 0,0055% et 22%, notamment égal à 6.6%. Le temps de recuit sous NH₃ est supérieur à 1 seconde, notamment compris entre 1 et 30 minutes.

A l'étape 5, on effectue une redescente en température._Les gaz porteurs sont N₂, N₂+H₂, ou H₂, de façon préférentielle N₂. Le gaz de nitruration injecté peut être de l'ammoniac (NH₃). La rampe de descente en température de T2 jusqu'à Tamb est supérieure à 1°C/min et notamment égale à 1°C/sec. Le débit d'ammoniac peut être compris entre 10xV/18 sccm et 4000xV/18 sccm, notamment égal à 1200xV/18 sccm (où V est le volume de l'enceinte en litres). De manière générale, le ratio des flux d'ammoniac sur azote (NH₃/N₂) peut être compris entre 0.0005% et 100%, de préférence entre 0,0055% et 22%, notamment égal à 6.6%.

Concernant cette alternative de la figure 9, l'étape de nitruration peut aussi être réalisée dans une enceinte de nitruration placée à une pression comprise entre 50 mbar et 800 mbar, notamment 100 mbar, et l'étape de croissance du nanofil (2) peut être réalisée après la deuxième sous-étape de nitruration (En2), ou est initiée au cours de la deuxième sous-étape de nitruration (En2).

Les étapes associées à la figure 5 sont préférablement mises en œuvre lorsque le métal de transition est le Ta (dans ce cas la première température est préférentiellement supérieure à la deuxième température lors de l'étape de nitruration). En effet, pour ce matériau on obtient une amélioration notable de la qualité des nanofils obtenus (verticalité, homogénéité de forme) par rapport à la variante de la figure 9. Inversement, et pour les même raisons, la variante de la figure 9 s'applique tout particulièrement lorsque l'on cherche à nitrurer le métal de transition de type : Ti , Zr, Hf, Nb (dans ce cas la première température est préférentiellement inférieure à la deuxième température lors de l'étape de nitruration).

Avantageusement, et ce de manière applicable à tout ce qui a été dit ci-dessus, lorsque le métal de transition déposé est du titane, la nitruration est réalisée en utilisant un gaz porteur qui comporte de l'hydrogène, notamment sous la forme H₂. Des tests ont démontré que dans ce cas le rendement de croissance de nanofils était amélioré lors de la présence d'hydrogène.

## Revendications

1. Procédé de croissance d'au moins un nanofil (3) semi-conducteur, ledit procédé de croissance comportant une étape de formation, au niveau d'un substrat (1), d'une couche de nucléation (2) pour la croissance du nanofil (3) et une étape de croissance du nanofil (3), **caractérisé en ce que** l'étape de formation de la couche de nucléation (2) comporte les étapes suivantes :
- le dépôt sur le substrat (1) d'une couche d'un métal de transition (4), ledit métal de transition étant le titane,
- la nitruration d'au moins une partie (2) de la couche de métal de transition de sorte à former une couche de métal de transition nitruré, ledit métal de transition nitruré étant le nitrure de titane, la couche de métal de transition nitruré présentant une surface destinée à la croissance du nanofil (3), la nitruration étant mise en œuvre avant la croissance du nanofil.

2. Procédé selon la revendication précédente, **caractérisé en ce que** l'étape de nitruration de ladite couche de métal de transition (4) est réalisée de sorte à modifier au moins en partie la structure cristallographique de la couche de métal de transition vers une structure cristallographique cubique face centrée, notamment orientée [111], ou hexagonale, notamment orientée [0001] ou selon la direction d'axe 'C', associée à la couche de métal de transition nitruré.

3. Procédé selon l'une des revendications 1 ou 2, **caractérisé en ce que** l'étape de nitruration comporte :
- une première sous-étape de nitruration (En1) réalisée au moins en partie à une première température,
- une deuxième sous-étape de nitruration (En2) réalisée au moins en partie à une deuxième température inférieure à la première température.

4. Procédé selon l'une des revendications 1 à 3, **caractérisé en ce que** l'étape de nitruration comporte :
- une première sous-étape de nitruration (En1) réalisée au moins en partie en imposant une injection d'un gaz de nitruration selon un premier débit,
- une deuxième sous-étape de nitruration (En2) réalisée au moins en partie en imposant une injection du gaz de nitruration selon un deuxième débit distinct du premier débit.

5. Procédé selon la revendication 3, **caractérisé en ce que** le gaz de nitruration injecté est de l'ammoniac, et **en ce que** :
- la première température est égale à 1050°C,
- la deuxième température est égale à 1000°C.

6. Procédé selon la revendication 4, **caractérisé en ce que** le gaz de nitruration injecté est de l'ammoniac, et **en ce que** :
- le premier débit est égal à 1600^{∗}V/8 sccm,
- le deuxième débit est égal à 500^{∗}V/8 sccm
où V est la capacité totale en litre d'une enceinte de nitruration correspondante.

7. Procédé selon l'une des revendications 1 ou 2, **caractérisé en ce que** l'étape de nitruration comporte :
- une première sous-étape de nitruration (En1) réalisée au moins en partie à une première température,
- une deuxième sous-étape de nitruration (En2) réalisée au moins en partie à une deuxième température supérieure ou égale à la première température.

8. Procédé selon l'une des revendications 1 ou 2 ou 7, **caractérisé en ce que** l'étape de nitruration comporte :
- une première sous-étape de nitruration (En1) réalisée au moins en partie en imposant une injection d'un gaz de nitruration selon un premier débit,
- une deuxième sous-étape de nitruration (En2) réalisée au moins en partie en imposant une injection du gaz de nitruration selon un deuxième débit distinct, ou non, du premier débit.

9. Procédé selon l'une des revendications 3 à 8, **caractérisé en ce que** l'étape de nitruration est réalisée dans une enceinte de nitruration placée à une pression comprise entre 50 mbar et 800 mbar, notamment 100 mbar.

10. Procédé selon l'une des revendications 3 à 9, **caractérisé en ce que** l'étape de croissance du nanofil (3) est réalisée après la deuxième sous-étape de nitruration (En2), ou est initiée au cours de la deuxième sous-étape de nitruration (En2).

11. Procédé selon l'une quelconque des revendications précédentes, **caractérisé en ce que** l'étape de croissance du nanofil (3) comporte une étape d'injection de Ga de sorte à former le nanofil en nitrure de gallium, ledit nanofil (3) s'étendant à partir de la surface de croissance de la couche de nucléation (2).

12. Procédé selon l'une quelconque des revendications précédentes, **caractérisé en ce que** ledit métal de transition est déposé à une température inférieure à 100°C.

13. Procédé selon l'une quelconque des revendications précédentes **caractérisé en ce que**, le substrat étant à base de silicium, l'étape de dépôt de la couche de métal de transition (4) comprend une étape préalable de détermination de l'épaisseur de la couche de métal de transition (4) à déposer comprenant :
- une étape de détermination d'une première longueur de diffusion du silicium dans la couche de métal de transition (4) au cours du futur dépôt de la couche de métal de transition (4) en fonction de la température de dépôt,
- une étape de détermination d'une deuxième longueur de diffusion du silicium dans la couche de métal de transition (4) au cours de la future étape de nitruration de la couche de métal de transition (4),
ladite épaisseur de la couche de métal de transition (4) à déposer étant fonction de l'épaisseur désirée de la couche de métal de transition nitruré et d'une épaisseur d'une tranche de métal de transition siliciuré obtenue dans la future couche de métal de transition (4) à partir des première et deuxième longueurs de diffusion déterminées.

14. Procédé selon l'une quelconque des revendications précédentes, **caractérisé en ce que** l'étape de dépôt de ladite couche de métal de transition et l'étape de nitruration sont mises en œuvre avant l'étape de croissance.

15. Procédé de fabrication d'un dispositif opto-électronique, **caractérisé en ce qu'**il comporte :
- une étape de mise en œuvre du procédé de croissance selon l'une des revendications précédentes,
- le dopage électrique d'un premier type d'au moins une extrémité (3a) du nanofil (3) opposée au substrat (1),
- la formation d'un élément (9) dopé électriquement d'un deuxième type opposé au premier type au niveau de l'extrémité (3a) du nanofil (3) opposée au substrat (1).

## Patentansprüche

1. Verfahren zur Züchtung von mindestens einem Halbleiter-Nanodraht (3), wobei das Züchtungsverfahren einen Schritt der Bildung, auf der Ebene eines Substrats (1), einer Nukleierungsschicht (2) zur Züchtung des Nanodrahts (3) und einen Schritt der Züchtung des Nanodrahts (3) umfasst,
**dadurch gekennzeichnet, dass** der Schritt der Bildung der Nukleierungsschicht (2) die folgenden Schritte umfasst:
- Abscheiden, auf dem Substrat (1), einer Schicht eines Übergangsmetalls (4), wobei das Übergangsmetall Titan ist,
- Nitrieren mindestens eines Teils (2) der Übergangsmetallschicht, um eine nitrierte Übergangsmetallschicht zu bilden, wobei das nitrierte Übergangsmetall Titannitrid ist, wobei die nitrierte Übergangsmetallschicht eine Fläche aufweist, die zur Züchtung des Nanodrahts (3) bestimmt ist, wobei die Nitrierung vor der Züchtung des Nanodrahts durchgeführt wird.

2. Verfahren nach dem vorhergehenden Anspruch, **dadurch gekennzeichnet, dass** der Schritt der Nitrierung der Übergangsmetallschicht (4) durchgeführt wird, um mindestens teilweise die kristallografische Struktur der Übergangsmetallschicht zu einer kubischen kristallografischen Struktur mit zentrierter, insbesondere [111] orientierter, oder hexagonaler, insbesondere [0001] orientierter, Fläche oder gemäß der Achsrichtung 'C', die mit der nitrierten Übergangsmetallschicht assoziiert ist, zu modifizieren.

3. Verfahren nach einem der Ansprüche 1 oder 2, **dadurch gekennzeichnet, dass** der Nitrierungsschritt umfasst:
- einen ersten Teilschritt der Nitrierung (En1), der mindestens teilweise bei einer ersten Temperatur durchgeführt wird,
- einen zweiten Teilschritt der Nitrierung (En2), der mindestens teilweise bei einer zweiten Temperatur durchgeführt wird, die niedriger ist als die erste Temperatur.

4. Verfahren nach einem der Ansprüche 1 bis 3, **dadurch gekennzeichnet, dass** der Nitrierungsschritt umfasst:
- einen ersten Teilschritt der Nitrierung (En1), der mindestens teilweise durchgeführt wird, indem eine Einspritzung eines Nitrierungsgases gemäß einem ersten Durchsatz angewendet wird,
- einen zweiten Teilschritt der Nitrierung (En2), der mindestens teilweise durchgeführt wird, indem eine Einspritzung des Nitrierungsgases gemäß einem zweiten Durchsatz angewendet wird, der von dem ersten Durchsatz verschieden ist.

5. Verfahren nach Anspruch 3,
**dadurch gekennzeichnet, dass** das eingespritzte Nitrierungsgas Ammoniak ist, und dadurch, dass:
- die erste Temperatur gleich 1050 °C ist,
- die zweite Temperatur gleich 1000 °C ist.

6. Verfahren nach Anspruch 4,
**dadurch gekennzeichnet, dass** das eingespritzte Nitrierungsgas Ammoniak ist, und dadurch, dass:
- der erste Durchsatz gleich 1600^{∗}V/8 sccm ist,
- der zweite Durchsatz gleich 500^{∗}V/8 sccm ist, wobei V die Gesamtkapazität in Liter einer entsprechenden Nitrierungsumhüllung ist.

7. Verfahren nach einem der Ansprüche 1 oder 2, **dadurch gekennzeichnet, dass** der Nitrierungsschritt umfasst:
- einen ersten Teilschritt der Nitrierung (En1), der mindestens teilweise bei einer ersten Temperatur durchgeführt wird,
- einen zweiten Teilschritt der Nitrierung (En2), der mindestens teilweise bei einer zweiten Temperatur durchgeführt wird, die größer oder gleich der ersten Temperatur ist.

8. Verfahren nach einem der Ansprüche 1 oder 2 oder 7, **dadurch gekennzeichnet, dass** der Nitrierungsschritt umfasst:
- einen ersten Teilschritt der Nitrierung (En1), der mindestens teilweise durchgeführt wird, indem eine Einspritzung eines Nitrierungsgases gemäß einem ersten Durchsatz angewendet wird,
- einen zweiten Teilschritt der Nitrierung (En2), der mindestens teilweise durchgeführt wird, indem eine Einspritzung des Nitrierungsgases gemäß einem zweiten Durchsatz angewendet wird, der von dem ersten Durchsatz verschieden ist oder nicht.

9. Verfahren nach einem der Ansprüche 3 bis 8, **dadurch gekennzeichnet, dass** der Nitrierungsschritt in einer Nitrierungsumhüllung durchgeführt wird, die einem Druck zwischen 50 mbar und 800 mbar, insbesondere 100 mbar, ausgesetzt wird.

10. Verfahren nach einem der Ansprüche 3 bis 9, **dadurch gekennzeichnet, dass** der Schritt der Züchtung des Nanodrahts (3) nach dem zweiten Teilschritt der Nitrierung (En2) durchgeführt wird, oder während des zweiten Teilschritts der Nitrierung (En2) initiiert wird.

11. Verfahren nach einem der vorhergehenden Ansprüche, **dadurch gekennzeichnet, dass** der Schritt der Züchtung des Nanodrahts (3) einen Schritt des Einspritzens von Ga umfasst, um den Nanodraht aus Galliumnitrid zu bilden, wobei sich der Nanodraht (3) von der Züchtungsfläche der Nukleierungsschicht (2) erstreckt.

12. Verfahren nach einem der vorhergehenden Ansprüche, **dadurch gekennzeichnet, dass** das Übergangsmetall bei einer Temperatur von weniger als 100 °C abgeschieden wird.

13. Verfahren nach einem der vorhergehenden Ansprüche, **dadurch gekennzeichnet, dass**, da das Substrat auf Silicium basiert, der Schritt der Abscheidung der Übergangsmetallschicht (4) einen vorherigen Schritt der Bestimmung der Dicke der abzuscheidenden Übergangsmetallschicht (4) umfasst, umfassend:
- einen Schritt der Bestimmung einer ersten Diffusionslänge von Silicium in der Übergangsmetallschicht (4) während der zukünftigen Abscheidung der Übergangsmetallschicht (4) als Funktion der Abscheidungstemperatur,
- einen Schritt der Bestimmung einer zweiten Diffusionslänge von Silicium in der Übergangsmetallschicht (4) während des zukünftigen Schritts der Nitrierung der Übergangsmetallschicht (4), wobei die Dicke der abzuscheidenden Übergangsmetallschicht (4) eine Funktion ist der gewünschten Dicke der nitrierten Übergangsmetallschicht und einer Dicke einer Tranche eines silicierten Übergangsmetalls, die in der zukünftigen Übergangsmetallschicht (4) aus der ersten und zweiten bestimmten Diffusionslänge erhalten wird.

14. Verfahren nach einem der vorhergehenden Ansprüche, **dadurch gekennzeichnet, dass** der Schritt der Abscheidung der Übergangsmetallschicht und der Nitrierungsschritt vor dem Züchtungsschritt durchgeführt werden.

15. Verfahren zur Herstellung einer opto-elektronischen Vorrichtung,
**dadurch gekennzeichnet, dass** dieses umfasst:
- einen Schritt der Durchführung des Züchtungsverfahrens nach einem der vorhergehenden Ansprüche,
- die elektrische Dotierung eines ersten Typs mindestens eines Endes (3a) des Nanodahts (3), das dem Substrat (1) gegenüberliegt,
- die Bildung eines Elements (9), das elektrisch mit einem zweiten Typ, entgegengesetzt zum ersten Typ, auf der Ebene des Endes (3a) des Nanodrahts (3) dotiert ist, das dem Substrat (1) gegenüberliegt.

## Claims

1. A process for growing at least one semiconductor nanowire (3), said growing process comprising a step of forming, on a substrate (1), a nucleation layer (2) for the growth of the nanowire (3) and a step of growth of the nanowire (3), **characterized in that** the step of forming the nucleation layer (2) comprises the following steps:
- deposition onto the substrate (1) of a layer of a transition metal (4), said transition metal being titanium,
- nitridation of at least part (2) of the transition metal layer so as to form a transition metal nitride layer, said transition metal nitride being titanium nitride, the transition metal nitride layer having a surface intended for the growth of the nanowire (3), the nitridation being performed before the nanowire growth.

2. The process as claimed in the preceding claim, **characterized in that** the step of nitridation of said transition metal layer (4) is performed so as to at least partly modify the crystallographic structure of the transition metal layer toward a face-centered cubic crystallographic structure, which is especially oriented [111], or hexagonal crystallographic structure, which is especially oriented [0001] or along the direction of the axis "C", associated with the transition metal nitride layer.

3. The process as claimed in either of claims 1 and 2, **characterized in that** the nitridation step comprises:
- a first nitridation substep (En1) at least partly performed at a first temperature,
- a second nitridation substep (En2) at least partly performed at a second temperature less than the first temperature.

4. The process as claimed in one of claims 1 to 3, **characterized in that** the nitridation step comprises:
- a first nitridation substep (En1) at least partly performed by imposing an injection of a nitridation gas at a first flow rate,
- a second nitridation substep (En2) at least partly performed by imposing an injection of the nitridation gas at a second flow rate different from the first flow rate.

5. The process as claimed in claim 3, **characterized in that** the injected nitridation gas is ammonia, and **in that**:
- the first temperature is equal to 1050°C,
- the second temperature is equal to 1000°C.

6. The process as claimed in claim 4, **characterized in that** the injected nitridation gas is ammonia, and **in that**:
- the first flow rate is equal to 1600^{∗}V/8 sccm,
- the second flow rate is equal to 500^{∗}V/8 sccm in which V is the total capacity in liters of a corresponding nitridation chamber.

7. The process as claimed in either of claims 1 and 2, **characterized in that** the nitridation step comprises:
- a first nitridation substep (En1) at least partly performed at a first temperature,
- a second nitridation substep (En2) at least partly performed at a second temperature greater than or equal to the first temperature.

8. The process as claimed in either of claims 1 and 2 and 7, **characterized in that** the nitridation step comprises:
- a first nitridation substep (En1) at least partly performed by imposing an injection of a nitridation gas at a first flow rate,
- a second nitridation substep (En2) at least partly performed by imposing an injection of the nitridation gas at a second flow rate which may or may not be different from the first flow rate.

9. The process as claimed in one of claims 3 to 8, **characterized in that** the nitridation step is performed in a nitridation chamber placed at a pressure of between 50 mbar and 800 mbar, especially 100 mbar.

10. The process as claimed in one of claims 3 to 9, **characterized in that** the step of growth of the nanowire (3) is performed after the second nitridation substep (En2), or is initiated during the second nitridation substep (En2).

11. The process as claimed in any one of the preceding claims, **characterized in that** the step of growth of the nanowire (3) comprises a step of injection of Ga so as to form the gallium nitride nanowire, said nanowire (3) extending from the growth surface of the nucleation layer (2).

12. The process as claimed in any one of the preceding claims, **characterized in that** said transition metal is deposited at a temperature below 100°C.

13. The process as claimed in any one of the preceding claims, **characterized in that**, with the substrate being based on silicon, the step of depositing the transition metal layer (4) comprises a preliminary step of determining the thickness of the transition metal layer (4) to be deposited, comprising:
- a step of determining a first diffusion length of silicon into the transition metal layer (4) during the future deposition of the transition metal layer (4) as a function of the deposition temperature,
- a step of determining a second diffusion length of silicon into the transition metal layer (4) during the future step of nitridation of the transition metal layer (4),
said thickness of the transition metal layer (4) to be deposited being dependent on the desired thickness of the transition metal nitride layer and on a thickness of a silicidized slice of transition metal obtained in the future transition metal layer (4) from the first and second determined diffusion lengths.

14. The process as claimed in any one of the preceding claims, **characterized in that** the step of depositing said transition metal layer and the nitridation step are implemented before the growth step.

15. A process for manufacturing an optoelectronic device, **characterized in that** it comprises:
- a step of performing the growth process as claimed in one of the preceding claims,
- electrical doping of a first type of at least one end (3a) of the nanowire (3) opposite the substrate (1),
- the formation of an electrically doped element (9) of a second type opposite the first type at the end (3a) of the nanowire (3) opposite the substrate (1).
